# EUROPEAN PATENT SPECIFICATION

(11) **EP 2 880 644 B1**
(45) Date of publication and mention of the grant of the patent: **23.12.2020**
(21) Application number: 13748420.0
(22) Date of filing: 31.07.2013
(51) Int. Cl.: G08B 17/10, G01R 27/26, G08B 17/113

(54) **SMOKE DETECTION USING CHANGE IN PERMITTIVITY OF CAPACITOR AIR DIELECTRIC**
RAUCHDETEKTION MITHILFE VON ÄNDERUNGEN IN DER DURCHLÄSSIGKEIT EINES KONDENSATOR-LUFTDIELEKTRIKUMS
DÉTECTION DE FUMÉE À L'AIDE DE CHANGEMENT DE PERMITTIVITÉ DE DIÉLECTRIQUE À AIR DE CONDENSATEUR

(30) Priority: 01.08.2012 US 201213564493
(43) Date of publication of application: 10.06.2015
(73) Proprietor: Microchip Technology Incorporated, Chandler, AZ 85224-6199 (US)
(72) Inventor: COOKE, Benjamin T., Denver, CO 80222 (US); JULICHER, Joseph, Maricopa, AZ 85138 (US); CURTIS, Keith, Gilbert, AZ 85297 (US)
(74) Representative: sgb europe
(86) International application number: PCT/US2013/052956
(87) International publication number: WO 2014/022525

(56) References cited:
- CN-A- 101 294 923
- FR-A1- 2 473 201
- GB-A- 2 117 560
- US-A- 4 222 045
- US-A- 4 652 866
- US-A1- 2008 272 826
- US-A1- 2010 181 180
- US-A1- 2011 007 028
- US-B2- 7 460 441
- US-B2- 7 764 213

## Description

The present disclosure relates to smoke detection devices, and more particularly, to a smoke detection device that uses a change in permittivity of air dielectric in a sensor capacitor as smoke passes between the capacitor plates.

A smoke detector generally uses an ionization chamber containing a radioactive ion source that is coupled to a high input impedance operational amplifier. However when operating at elevated temperatures the input leakage current of the operational amplifier increases. This affects overall performance of the ionization chamber smoke detection function. Also the ionization chamber contains radioactive materials that during manufacture necessitate compliance with regulatory requirements pertaining to storing and handling of these radioactive materials. The smoke detectors having ionization chambers containing a radioactive ion source are increasingly coming under stronger government regulatory control due to the radioactive element (ion source) contained therein.

An example for a capacitive smoke detector using a radioactive source is disclosed in GB2117560. An example for a capacitive smoke detector without the use of a radioactive source is disclosed in US4652866.

Therefore, a need exists for a way to detect smoke from a fire with a smoke detector that does not require a radioactive ionization chamber as part of the smoke detection sensor. This and other objects can be achieved by a smoke detector and method as defined in the independent claims. Further enhancements are characterized in the dependent claims.

According to an embodiment, a smoke detector using an air dielectric capacitor as a smoke sensor may comprise: an air dielectric capacitor having a plurality of plates, wherein when clean air flows over surfaces of the plurality of plates the air dielectric capacitor has a first capacitance value and when smoke is in the air flowing over the plurality of plates the air dielectric capacitor has a second capacitance value; a capacitance measurement circuit coupled to the air dielectric capacitor, wherein the capacitance measurement circuit measures a capacitance value of the air dielectric capacitor; and an alarm circuit coupled to the capacitance measurement circuit, wherein when the measured capacitance value is at substantially the second capacitance value the alarm circuit is actuated by the capacitance measurement circuit, and when the measured capacitance value is at substantially the first capacitance value the alarm circuit is not actuated.

Preferably the second capacitance value is greater than the first capacitance value. According to a further embodiment, there is a time limit for the air dielectric capacitor to change from the first capacitance value to the second capacitance value, otherwise the alarm circuit will not actuate. According to a further embodiment, the capacitance measurement circuit is a charge time measurement unit (CTMU) circuit. According to a further embodiment, the alarm circuit has a shutdown circuit. According to a further embodiment, a digital processor is coupled to the capacitance measurement circuit and the alarm circuit. According to a further embodiment, the digital processor is a microcontroller. According to a further embodiment, the capacitance measurement circuit, the alarm circuit and the digital processor are fabricated on an integrated circuit die.

According to a further embodiment, a temperature sensor is coupled to the digital processor and a temperature compensation look-up table is stored in a memory coupled to the digital processor and used to compensate temperature induced changes of the first and second capacitance values. According to a further embodiment, a humidity sensor is coupled to the digital processor and a humidity compensation look-up table is stored in a memory that is coupled to the digital processor and used to compensate humidity induced changes of the first and second capacitance values. According to a further embodiment, an audible alert is actuated by the alarm circuit. According to a further embodiment, a visual alert is actuated by the alarm circuit.

According to another embodiment, a smoke detector using an air dielectric capacitor as a smoke sensor may comprise: an air dielectric capacitor having a plurality of plates, wherein when clean air flows over surfaces of the plurality of plates the air dielectric capacitor has a first capacitance value and when smoke is in the air flowing over the plurality of plates the air dielectric capacitor has a second capacitance value; a capacitance change detection circuit coupled to the air dielectric capacitor, wherein the capacitance change detection circuit determines when the air dielectric capacitor changes from the first capacitance value to the second capacitance value; and an alarm circuit coupled to the capacitance change detection circuit, wherein when the capacitance change detection circuit indicates that the first capacitance value has changed to the second capacitance value the alarm circuit is actuated, otherwise the alarm circuit is not actuated.

Preferably the second capacitance value is greater than the first capacitance value. According to a further embodiment, the capacitance change detection circuit further comprises a time limit for the air dielectric capacitor to change from the first capacitance value to the second capacitance value, otherwise the alarm circuit will not actuate. According to a further embodiment, the capacitance change detection circuit is a capacitive voltage divider (CVD) circuit. According to a further embodiment, the capacitance change detection circuit is a capacitive sensing module (CSM) circuit.

According to a further embodiment, the capacitance change detection circuit may comprise: a frequency generation circuit using the air dielectric capacitor as part of a frequency determining circuit thereof; and a frequency discriminator circuit coupled to the frequency generation circuit, the frequency discriminator circuit has a first output when the air dielectric capacitor is at the first capacitance value and has a second output when the air dielectric capacitor is at the second capacitance value. According to a further embodiment, the alarm circuit further comprises a shutdown circuit.

According to a further embodiment, a digital processor is coupled to the capacitance change detection circuit and the alarm circuit. According to a further embodiment, the digital processor is a microcontroller. According to a further embodiment, the capacitance change detection circuit, the alarm circuit and the digital processor are fabricated on an integrated circuit die. According to a further embodiment, a temperature sensor is coupled to the digital processor and a temperature compensation look-up table stored in a memory coupled to the digital processor and used to compensate temperature induced changes of the first and second capacitance values. According to a further embodiment, a humidity sensor is coupled to the digital processor and a humidity compensation look-up table is stored in a memory coupled to the digital processor and used to compensate humidity induced changes of the first and second capacitance values. According to a further embodiment, an audible alert is actuated by the alarm circuit. According to a further embodiment, a visual alert is actuated by the alarm circuit.

According to still another embodiment, a method for detecting smoke in air may comprise the steps of: flowing clean air over a plurality of plates of an air dielectric capacitor; determining a capacitance value of the air dielectric capacitor when the clean air is flowing over the plurality of the plates of the air dielectric capacitor; detecting an increase in the capacitance value of the air dielectric capacitor indicating smoke in the flowing air; and generating a smoke alarm when the increase in the capacitance value of the air dielectric capacitor is detected.

According to yet another embodiment, a method for detecting smoke in air may comprise the steps of: flowing air over a plurality of plates of an air dielectric capacitor; detecting when an increase in a capacitance value of the air dielectric capacitor occurs, thereby indicating smoke in the flowing air; and generating a smoke alarm when the increase in the capacitance value of the air dielectric capacitor is detected.

A more complete understanding of the present disclosure may be acquired by referring to the following description taken in conjunction with the accompanying drawings wherein:
Figure 1 illustrates a schematic block diagram of smoke detection apparatus using an air dielectric capacitor as a smoke sensor, according to the teachings of this disclosure;
Figure 2 illustrates schematic side and front elevational views of an air dielectric capacitor used as a smoke sensor in a return air plenum, according to a specific example embodiment of this disclosure;
Figure 3 illustrates a schematic front view and a schematic elevational view of an air dielectric capacitor used as a smoke sensor in a ceiling mounted smoke detector, according to the embodiments of this disclosure;
Figure 4 illustrates a schematic block diagram of a smoke detection system, according to yet another specific example embodiment of this disclosure;
Figure 5 illustrates a schematic flow diagram of a smoke detection system, according to still another specific example embodiment of this disclosure; and
Figure 6 illustrates a schematic flow diagram of a smoke detection system, according to yet another specific example embodiment of this disclosure.

While the present disclosure is susceptible to various modifications and alternative forms, specific example embodiments thereof have been shown in the drawings and are herein described in detail. It should be understood, however, that the description herein of specific example embodiments is not intended to limit the disclosure to the particular forms disclosed herein, but on the contrary, this disclosure is to cover all modifications and equivalents as defined by the appended claims.

A capacitor having air dielectric between its plates may be used to detect the presence of smoke and other contaminants in the dielectric air passing over the plates of the capacitor, according to the teachings of this disclosure. Smoke from typical fires is mainly composed of unburned carbon that has diffused in the surrounding air and rises with the heat of the fire. The permittivity of the carbon particles is about 10 to 15 times the permittivity of clean air. The addition of the carbon particles into the air creates a change in the permittivity thereof that is large enough to measure by measuring a change in capacitance of the capacitor having the air dielectric through which the air laden carbon particles pass through. For example, even a small concentration of carbon particles in air, *e.g.,* 400 PPM, will cause the permittivity to change from about 1.00054 (clean air) to about 1.00494, thereby increasing the capacitance of a 22 picofarad capacitor by about 0.44 percent (.0967 picofarads = 96.7 femtofarads).

Humidity and temperature variations can make significant changes to the permittivity of air, but may be compensated for with external humidity and temperature sensors. Permittivity variations due to environmental humidity and temperature changes generally are over a longer time period than a sudden change in the amount of contaminates (carbon particles, *etc*.) in the air between the plates of the capacitor. Therefore an envelope detection or averaging process may be used to ignore the slow drift of capacitance due to humidity and/or temperature changes but recognize a more abrupt (rapid) change of the permittivity of air due to carbon particles suddenly showing up in the air dielectric of the sensor capacitor. Various techniques for measuring changes in capacitance may be used and are contemplated herein for all purposes. Those having ordinary skill in capacitor measurement circuits and the benefit of this disclosure could readily apply those capacitor measurement circuits in a smoke detection apparatus.

Referring now to the drawing, the details of specific example embodiments are schematically illustrated. Like elements in the drawings will be represented by like numbers, and similar elements will be represented by like numbers with a different lower case letter suffix.

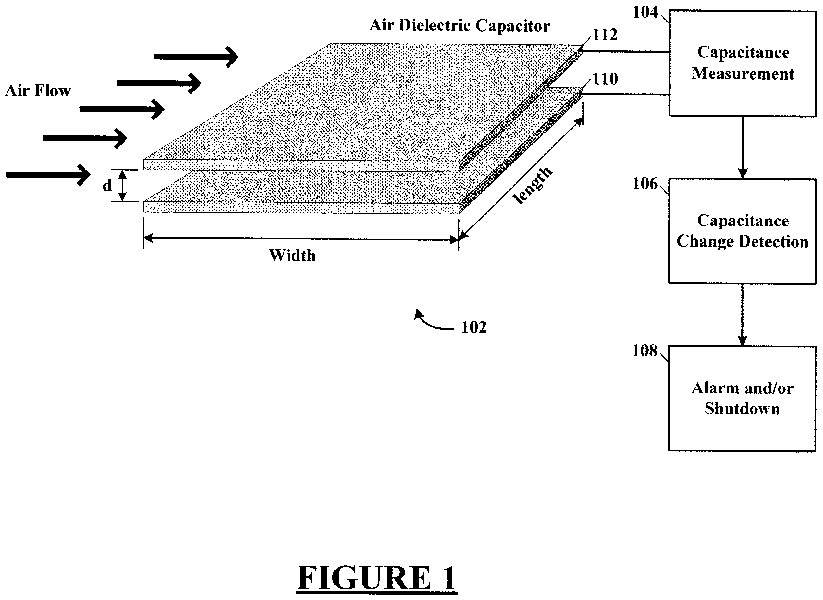

Referring to Figure 1, depicted is a schematic block diagram of smoke detection apparatus using an air dielectric capacitor as a smoke sensor, according to the teachings of this disclosure. An air dielectric capacitor, generally represented by the numeral 102, comprises a first conductive plate 110, a second conductive plate 112 and an insulated air dielectric therebetween. The capacitor 102 may be made from metal plates, conductive foil covered printed circuit boards, *etc.* A capacitance measurement circuit 104 is coupled to the first and second conductive plates 110 and 112, respectively, and is used to determine a capacitance value of the capacitor 102 caused by a change in the permittivity of the air dielectric between the first and second conductive plates 110 and 112. A capacitive change detection circuit 106 may be used to detect a change in the capacitance as measured by the capacitance measurement circuit 104. An alarm and/or shutdown circuit 108 may be coupled to the capacitive change detection circuit 106 and be adapted to alarm and/or shutdown equipment, *e.g.,* audible and visual alerts, shutdown an air handler blower, *etc.*

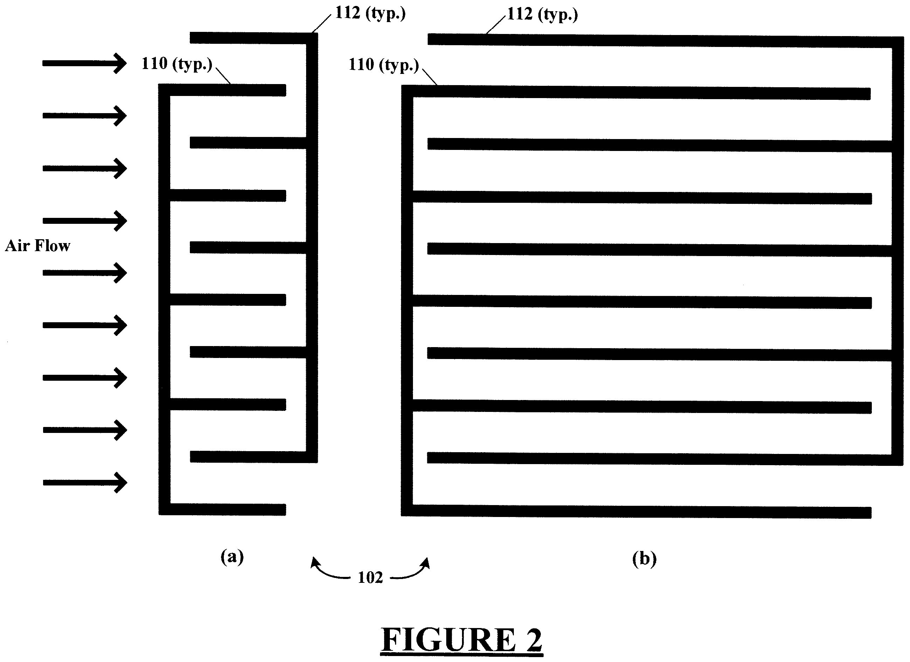

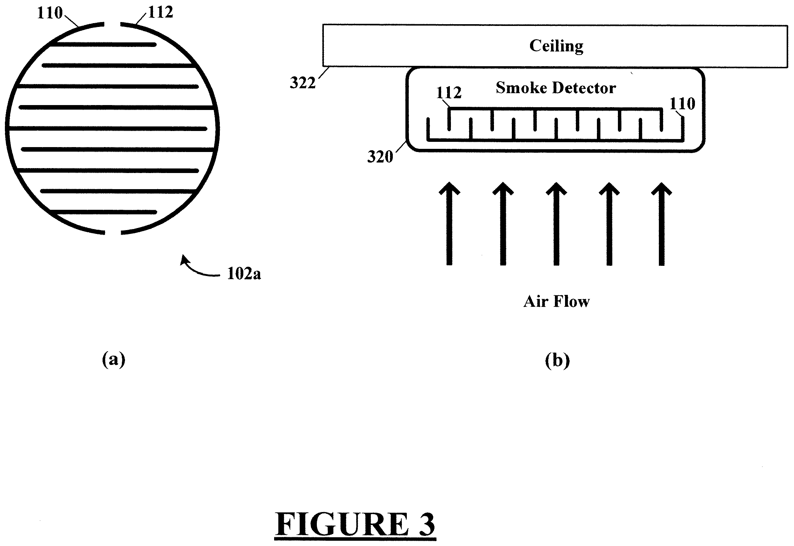

The capacitance, C, of the capacitor 102 is a function of the area, A= length x width, of the conductive plates 110 and 112, the distance, d, between the plates 110 and 112 facing each other, and the permittivity, ε, of the dielectric (air) therebetween according to the formula: C = εA/d. As multiple plates are added (see Figures 2 and 3), the capacitance increases proportionally, *e.g.*, C = εA/d ^{∗} (# plates -1). Preferably the capacitor 102 may have a capacitance value within an accurate capacitance measurement resolution range of the capacitance measurement circuit 104. The capacitor 102 may also be physically configured, *e.g.,* number of plates, plate separation, shape, *etc*., for a specific application, *e.g.,* return air duct mounted (Figure 2), ceiling mounted smoke alarm (Figure 3), *etc.*

The capacitance measurement circuit 104 may be any one or more capacitance measurement circuit that have the necessary capacitance resolution. For example, but not limited to, a Charge Time Measurement Unit (CTMU) may be used for very accurate capacitance measurements. The CTMU is more fully described in Microchip applications notes AN1250 and AN1375, available at www.microchip.com, and commonly owned U.S. Patent Nos. US 7,460,441 B2, entitled "Measuring a long time period;" and US 7,764,213 B2, entitled "Current-time digital-to-analog converter," both by James E. Bartling; wherein all of which are hereby incorporated by reference herein for all purposes.

Also the capacitance measurement circuit 104 and the capacitive change detection circuit 106 may be combined as a circuit to just detect a change in capacitance of the capacitor 102. For example, a Capacitive Voltage Divider (CVD) circuit may be used according to AN1298, available at www.microchip.com, and commonly owned U.S. Patent Application Publication No.: US 2010/0181180 A1, entitled "Capacitive Touch Sensing Using an Internal Capacitor of an Analog-to-Digital Converter (ADC) and a Voltage Reference" by Dieter Peter. A Capacitive Sensing Module (CSM) circuit may be used according to AN1171, AN1312 and AN1334, available at www.microchip.com, and commonly owned U.S. Patent Application No.: US 2011/0007028 A1, entitled "Capacitive Touch System With Noise Immunity" by Keith E. Curtis, *et al*.; wherein all of which are hereby incorporated by reference herein for all purposes.

Another capacitive change detection circuit may be a tuned circuit using the capacitor 102 as one of the frequency determining elements and a frequency discriminator circuit, as more fully described in commonly owned U.S. Patent Application Publication No.: US 2008/0272826 A1, entitled "Interrupt/Wake-Up of an Electronic Device in a Low Power Sleep Mode When Detecting a Sensor or Frequency Source Activated Frequency Change" by Zacharias Marthinus Smit, *et al*., and is hereby incorporated by reference herein for all purposes.

Referring now to Figure 2, depicted are schematic side and front elevational views of an air dielectric capacitor used as a smoke sensor in a return air plenum, according to a specific example embodiment of this disclosure. Figure 2(a) depicts the side elevational view of a multi-plate air dielectric capacitor 102 showing air flow direction over and through the plates. Figure 2(b) depicts the front elevational view of the multi-plate air dielectric capacitor 102 where air flow goes into the front of the multi-plate air dielectric capacitor 102. This physical configuration can be easily adapted to fit inside of an air supply and/or return plenum (not shown), or at the return or supply register (not shown). The plates 110 and 112 of the capacitor 102 may be metal or any other conductive material, *e.g*., conductive foil covered printed circuit boards.

Referring now to Figure 3, depicted are a schematic front view and a schematic elevational view of an air dielectric capacitor used as a smoke sensor in a ceiling mounted smoke detector, according to another specific embodiments of this disclosure. Figure 3(a) depicts the front view of a multi-plate air dielectric capacitor 102a that may be used in a ceiling mounted smoke detector 320. Figure 3(b) depicts the elevational view of the multi-plate air dielectric capacitor 102a in a smoke detector 320 mounted under a ceiling 322, showing air flow into the front lower portion of the smoke detector 320 where the multi-plate air dielectric capacitor 102a is located. As the heat and smoke from the fire rises, the smoke flows through the plates 110 and 112 of the smoke sensor capacitor 102a. This physical configuration for the smoke detector capacitor 102a may be adapted to fit inside any of the common smoke detectors used in residential and commercial buildings. The plates 110 and 112 of the capacitor 102a may be metal or any other conductive material, *e.g.,* conductive foil covered printed circuit boards.

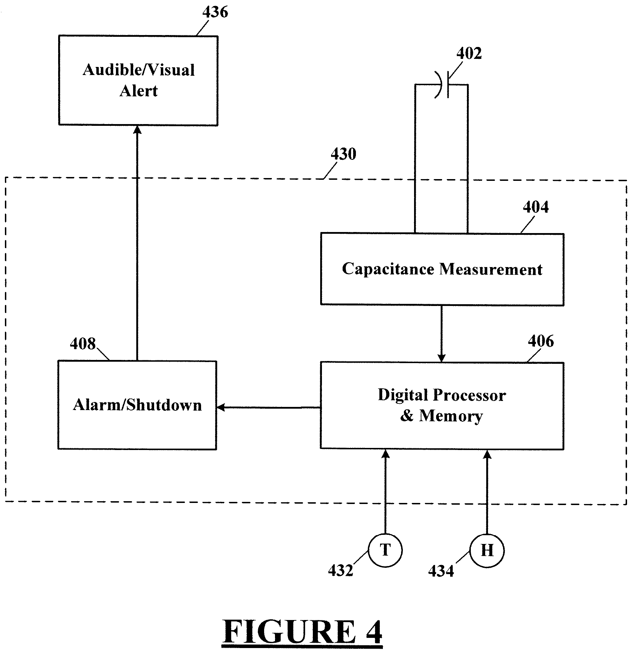

Referring now to Figure 4, depicted is a schematic block diagram of a smoke detection system, according to yet another specific example embodiment of this disclosure. The smoke detection system may comprise a capacitance measurement circuit 404 and/or a capacitance change detection circuit 106 coupled to a digital processor and memory 406. An alarm/shutdown driver(s) 408 coupled to an output(s) of the digital processor and memory 406 may be used to drive an audible and/or visual alert signal. The alarm/shutdown driver 408 may also drive a shutdown circuit in the application of an air handler blower pushing air into a plenum where the smoke detector may be located. The smoke detector capacitor 402 is coupled to the capacitance measurement circuit 404 or the capacitance change detection circuit 106 having a capacitance measurement circuit 404 incorporated therein.

The digital processor 406 may further be coupled to temperature and/or humidity sensors 432 and 434, respectively, and have some type of compensation means to adjust the capacitance measurements that may change under different temperature and humidity conditions, *e.g*., using look-up tables that contain calibration and compensation data for the smoke sensor capacitor 402. In addition, the digital processor 406 may have smoothing, time averaging, noise suppression, over sampling, and/or digital signal processing to enhance the capacitance change detection sensitivity and/or reduce noise pick-up. The capacitance measurement circuit 404, the digital processor and memory 406, and the alarm/shutdown driver(s) 408 may be fabricated on an integrated circuit die 430. The integrated circuit die 430 may be encapsulated in an integrated circuit package (not shown).

The digital processor 406 may be, for example but is not limited to, a microcontroller, a microprocessor, a digital signal processor (DSP), a programmable logic array (PLA), an application specific integrated circuit (ASIC), *etc.* The memory may be volatile and/or nonvolatile memory. A software and/or firmware operating program, and temperature and/or humidity compensation table(s) may be stored in the memory coupled to the digital processor 406. The temperature and/or humidity compensation table(s) may be defined during testing of the integrated circuit device 430 by measuring the capacitance or change thereof and correlating any changes to that capacitance as a function of temperature and/or humidity.

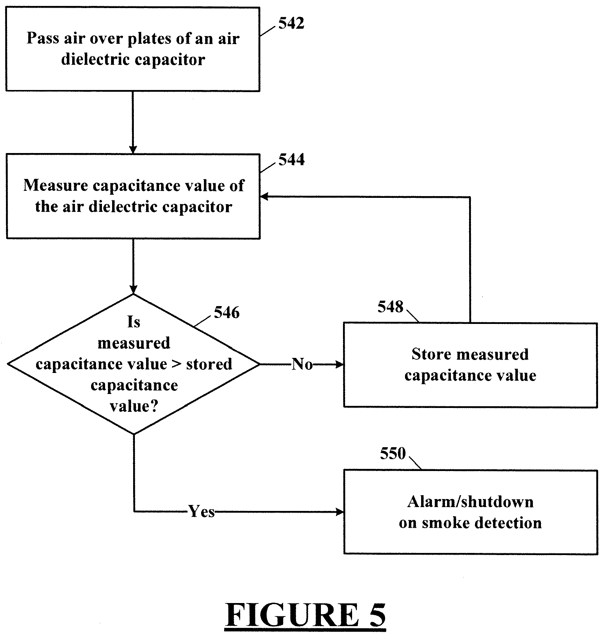

Referring to Figure 5, depicted is a schematic flow diagram of a smoke detection system, according to still another specific example embodiment of this disclosure. In step 542 air is passed over plates of an air dielectric capacitor. In step 544 a capacitance value is measured for the air dielectric capacitor. In step 546 a determination is made whether the measured capacitance value is greater than a stored capacitance value determined previously. If the presently measured capacitance value is about the same value as the stored capacitance value then the presently measured capacitance is stored in step 548, then step 544 is repeated and a new capacitance value is measure. However, if the presently measured capacitance value is greater than the stored capacitance value then a smoke alarm is generated in step 550.

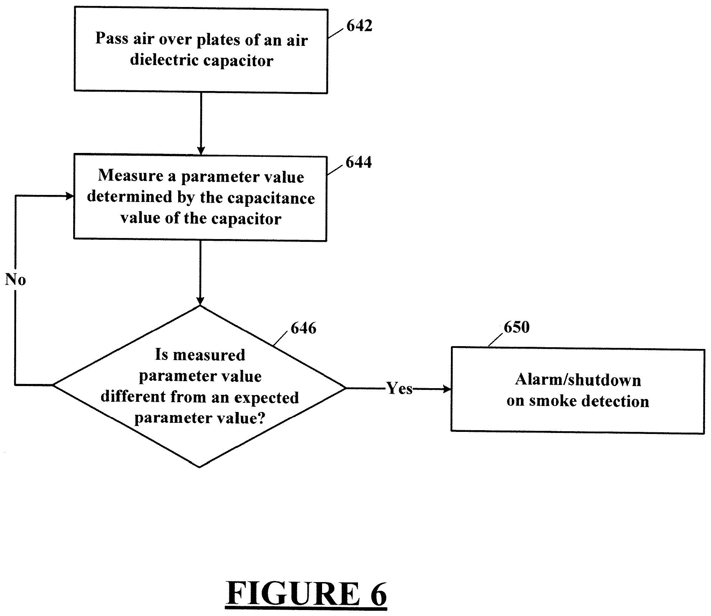

Referring to Figure 6, depicted is a schematic flow diagram of a smoke detection system, according to yet another specific example embodiment of this disclosure. In step 642 air is passed over plates of an air dielectric capacitor. In step 644 a parameter value is determined by the capacitance of the air dielectric capacitor. In step 646 a determination is made whether the parameter value is greater than an expected parameter value. If the parameter value is about the same value as the expected parameter value then step 644 is repeated and a new parameter value is measure. However, if the presently measured parameter value is different then the expected parameter value then a smoke alarm is generated in step 650.

While embodiments of this disclosure have been depicted, described, and are defined by reference to example embodiments of the disclosure, such references do not imply a limitation on the disclosure, and no such limitation is to be inferred. The subject matter disclosed is capable of considerable modification, alteration, and equivalents in form and function, as will occur to those ordinarily skilled in the pertinent art and having the benefit of this disclosure. The depicted and described embodiments of this disclosure are examples only.

## Claims

1. A smoke detector using an air dielectric capacitor as a smoke sensor without the use of a radioactive source, said smoke detector comprising:
an air dielectric capacitor (102; 402) having a plurality of plates (110, 112), wherein when clean air flows over surfaces of the plurality of plates, the air dielectric capacitor (102; 402) has a first capacitance value and when smoke is in the air flowing over the plurality of plates, the air dielectric capacitor (102; 402) has a second capacitance value, wherein the second capacitance value is preferably greater than the first capacitance value;
a capacitance measurement circuit (404) coupled to the air dielectric capacitor (402), wherein the capacitance measurement circuit (404) measures a capacitance value or a change in capacitance value of the air dielectric capacitor (404); and
an alarm circuit (406) coupled to the capacitance measurement circuit (404), wherein the alarm circuit is actuated based on the measured capacitance value or the measured change in capacitance value,
**characterized in that**
the plurality of plates (110; 112) of the air dielectric capacitor (102; 402) is arranged such that an inter-digital structure is formed by the plates.

2. The smoke detector according to claim 1, wherein the capacitance measurement circuit (404) is a peripheral device of an integrated circuit microcontroller (430) that is connected with the air dielectric capacitor (102; 402).

3. The smoke detector according to one of the preceding claims, wherein the capacitance measurement circuit (404) further comprises a time limit for the air dielectric capacitor to change from the first capacitance value to the second capacitance value, otherwise the alarm circuit will not actuate.

4. The smoke detector according to one of the preceding claims, wherein the capacitance measurement circuit (404) is a charge time measurement unit (CTMU) circuit.

5. The smoke detector according to one of the preceding claims 1-3, wherein the capacitance measurement circuit is a capacitive voltage divider (CVD) circuit or a capacitive sensing module (CSM) circuit.

6. The smoke detector according to one of the preceding claims 1-3, wherein the capacitance measurement circuit comprises:
a frequency generation circuit using the air dielectric capacitor (102; 402) as part of a frequency determining circuit thereof; and
a frequency discriminator circuit coupled to the frequency generation circuit, the frequency discriminator circuit has a first output when the air dielectric capacitor (102; 402) is at the first capacitance value and has a second output when the air dielectric capacitor is at the second capacitance value.

7. The smoke detector according to one of the preceding claims, wherein the alarm circuit further comprises a shutdown circuit (408).

8. The smoke detector according to one of the preceding claims, further comprising a digital processor (406) coupled to the capacitance measurement circuit (404) and the alarm circuit (408) wherein the capacitance measurement circuit (404), the alarm circuit (408) and the digital processor (406) are preferably fabricated on an integrated circuit die.

9. The smoke detector according to one of the preceding claims, wherein the air dielectric capacitor is mounted within a return air plenum.

10. The smoke detector according to one of the preceding claims 8 or 9, further comprising a temperature sensor (432) coupled to the digital processor (406) and a temperature compensation look-up table stored in a memory coupled to the digital processor (406) and used to compensate temperature induced changes of the first and second capacitance values.

11. The smoke detector according to one of the preceding claims 8-10, further comprising a humidity sensor (434) coupled to the digital processor (406) and a humidity compensation look-up table stored in a memory coupled to the digital processor (406) and used to compensate humidity induced changes of the first and second capacitance values.

12. The smoke detector according to one of the preceding claims, further comprising an audible alert (436) and/or a visual alert (436) actuated by the alarm circuit (408).

13. The smoke detector according to one of the preceding claims, wherein the air dielectric capacitor (102a) comprises two outer semi-circle shaped shells (110, 112) arranged at a distance to form a circle, wherein from an inner surface of each shell (110, 112) fingers extend alternatingly such that the inter-digital structure is formed.

14. A method for detecting smoke in air using a smoke detector according to one of the preceding claims, said method comprising the steps of:
flowing air over the plates of the air dielectric capacitor (102; 402);
detecting when an increase in a capacitance value of the air dielectric capacitor (102; 402) occurs, thereby indicating smoke in the flowing air; and
generating a smoke alarm when the increase in the capacitance value of the air dielectric capacitor (102; 402) is detected.

15. The method according to claim 14, wherein for determining a baseline, the method further comprises the steps of:
flowing clean air over the plates of the air dielectric capacitor (102; 402);
determining a capacitance value of the air dielectric capacitor (102; 402) when the clean air is flowing over the plurality of the plates of the air dielectric capacitor (102; 402).

## Patentansprüche

1. Rauchmelder, der einen Luftdielektrizitätskondensator als Rauchsensor ohne Verwendung einer radioaktiven Quelle verwendet, wobei der Rauchmelder aufweist:
einen Luftdielektrizitätskondensator (102; 402), der eine Vielzahl von Platten (110, 112) aufweist, wobei, wenn saubere Luft über Oberflächen der Vielzahl von Platten strömt, der Luftdielektrizitätskondensator (102; 402) einen ersten Kapazitätswert aufweist und wenn Rauch in der Luft ist, die über die Vielzahl von Platten strömt, der Luftdielektrizitätskondensator (102; 402) einen zweiten Kapazitätswert aufweist, wobei der zweite Kapazitätswert vorzugsweise größer ist als der erste Kapazitätswert;
eine Kapazitätsmessschaltung (404), die mit dem Luftdielektrizitätskondensator (402) gekoppelt ist, wobei die Kapazitätsmessschaltung (404) einen Kapazitätswert oder eine Änderung des Kapazitätswerts des Luftdielektrizitätskondensators (404) misst; und
eine Alarmschaltung (406), die mit der Kapazitätsmessschaltung (404) gekoppelt ist, wobei die Alarmschaltung basierend auf dem gemessenen Kapazitätswert oder der gemessenen Änderung des Kapazitätswerts betätigt wird;
**dadurch gekennzeichnet, dass**
die Vielzahl von Platten (110; 112) des Luftdielektrizitätskondensators (102; 402) derart angeordnet ist, dass durch die Platten eine interdigitale Struktur ausgebildet wird.

2. Rauchmelder gemäß Anspruch 1, wobei die Kapazitätsmessschaltung (404) eine Peripherievorrichtung einer integrierten Mikrocontrollerschaltung (430) ist, die mit dem Luftdielektrizitätskondensator (102; 402) verbunden ist.

3. Rauchmelder gemäß einem der vorhergehenden Ansprüche, wobei die Kapazitätsmessschaltung (404) weiterhin eine Zeitbegrenzung für den Luftdielektrizitätskondensator aufweist, um vom ersten Kapazitätswert zum zweiten Kapazitätswert zu wechseln, andernfalls die Alarmschaltung nicht betätigt wird.

4. Rauchmelder gemäß einem der vorhergehenden Ansprüche, wobei die Kapazitätsmessschaltung (404) eine Ladezeitmesseinheit (CTMU) ist.

5. Rauchmelder gemäß einem der vorhergehenden Ansprüche 1 bis 3, wobei die Kapazitätsmessschaltung eine kapazitive Spannungsteiler- (CVD-) Schaltung oder eine kapazitive Sensormodul- (CSM-) Schaltung ist.

6. Rauchmelder gemäß einem der vorhergehenden Ansprüche 1 bis 3, wobei die Kapazitätsmessschaltung aufweist:
eine Frequenzerzeugungsschaltung, die den Luftdielektrizitätskondensator (102; 402) als Teil einer Frequenzbestimmungsschaltung davon verwendet; und
eine Frequenzdiskriminatorschaltung, die mit der Frequenzerzeugungsschaltung gekoppelt ist, wobei die Frequenzdiskriminatorschaltung eine erste Ausgabe aufweist, wenn der Luftdielektrizitätskondensator (102; 402) den ersten Kapazitätswert aufweist, und eine zweite Ausgabe aufweist, wenn der Luftdielektrizitätskondensator den zweiten Kapazitätswert aufweist.

7. Rauchmelder gemäß einem der vorhergehenden Ansprüche, wobei die Alarmschaltung weiterhin eine Abschaltschaltung (408) aufweist.

8. Rauchmelder gemäß einem der vorhergehenden Ansprüche, der weiterhin einen digitalen Prozessor (406) aufweist, der mit der Kapazitätsmessschaltung (404) und der Alarmschaltung (408) gekoppelt ist, wobei die Kapazitätsmessschaltung (404), die Alarmschaltung (408) und der digitale Prozessor (406) vorzugsweise auf einem integrierten Schaltungschip hergestellt sind.

9. Rauchmelder gemäß einem der vorhergehenden Ansprüche, wobei der Luftdielektrizitätskondensator in einer Rückluftkammer montiert ist.

10. Rauchmelder gemäß einem der vorhergehenden Ansprüche 8 oder 9, der weiterhin einen Temperatursensor (432) aufweist, der mit dem digitalen Prozessor (406) gekoppelt ist, und eine Temperaturkompensations-Nachschlagetabelle, die in einem mit dem digitalen Prozessor (406) gekoppelten Speicher gespeichert ist und verwendet wird, um temperaturbedingte Änderungen der ersten und zweiten Kapazitätswerte zu kompensieren.

11. Rauchmelder gemäß einem der vorhergehenden Ansprüche 8 bis 10, der weiterhin einen Feuchtigkeitssensor (434) aufweist, der mit dem digitalen Prozessor (406) gekoppelt ist, und eine Nachschlagetabelle zur Feuchtigkeitskompensation, die in einem mit dem digitalen Prozessor (406) gekoppelten Speicher gespeichert ist und verwendet wird, um feuchtigkeitsbedingte Änderungen der ersten und zweiten Kapazitätswerte zu kompensieren.

12. Rauchmelder gemäß einem der vorhergehenden Ansprüche, der weiterhin einen akustischen Alarm (436) und/oder einen visuellen Alarm (436) aufweist, der von der Alarmschaltung (408) betätigt wird.

13. Rauchmelder gemäß einem der vorhergehenden Ansprüche, wobei der Luftdielektrizitätskondensator (102a) zwei äußere halbkreisförmige Schalen (110, 112) aufweist, die in einem Abstand angeordnet sind, um einen Kreis zu bilden, wobei sich von einer Innenfläche jeder Schale (110, 112) abwechselnd Finger derart erstrecken, dass die interdigitale Struktur ausgebildet wird.

14. Verfahren zum Detektieren von Rauch in Luft unter Verwendung eines Rauchmelders gemäß einem der vorhergehenden Ansprüche, wobei das Verfahren die folgenden Schritte aufweist:
Strömen von Luft über die Platten des Luftdielektrizitätskondensators (102; 402);
Detektieren, wann eine Erhöhung eines Kapazitätswerts des Luftdielektrizitätskondensators (102; 402) auftritt, wodurch Rauch in der strömenden Luft angezeigt wird; und
Erzeugen eines Rauchalarms, wenn die Erhöhung des Kapazitätswerts des Luftdielektrizitätskondensators (102; 402) detektiert wird.

15. Verfahren gemäß Anspruch 14, wobei das Verfahren zum Bestimmen eines Ausgangswerts weiterhin die Schritte aufweist:
Strömen sauberer Luft über die Platten des Luftdielektrizitätskondensators (102; 402);
Bestimmen eines Kapazitätswerts des Luftdielektrizitätskondensators (102; 402), wenn die saubere Luft über die Vielzahl von Platten des Luftdielektrizitätskondensators (102; 402) strömt.

## Revendications

1. Détecteur de fumée utilisant un condensateur à diélectrique à air en tant que capteur de fumée sans l'utilisation d'une source radioactive, ledit détecteur de fumée comprenant :
un condensateur à diélectrique à air (102 ; 402) ayant une pluralité de plaques (110, 112), dans lequel, lorsque de l'air propre s'écoule sur les surfaces de la pluralité de plaques, le condensateur à diélectrique à air (102 ; 402) a une première valeur de capacité et lorsque de la fumée est dans l'air s'écoulant sur la pluralité de plaques, le condensateur à diélectrique à air (102 ; 402) a une deuxième valeur de capacité, dans lequel la deuxième valeur de capacité est de préférence supérieure à la première valeur de capacité ;
un circuit de mesure de capacité (404) couplé au condensateur à diélectrique à air (402), dans lequel le circuit de mesure de capacité (404) mesure une valeur de capacité ou un changement de valeur de capacité du condensateur à diélectrique à air (404) ; et
un circuit d'alarme (406) couplé au circuit de mesure de capacité (404), dans lequel le circuit d'alarme est actionné sur la base de la valeur de capacité mesurée ou du changement mesuré de valeur de capacité,
**caractérisé en ce que**
la pluralité de plaques (110 ; 112) du condensateur à diélectrique à air (102 ; 402) est agencé de sorte qu'une structure interdigitale est formée par les plaques.

2. Détecteur de fumée selon la revendication 1, dans lequel le circuit de mesure de capacité (404) est un dispositif périphérique d'un microcontrôleur à circuit intégré (430) qui est connecté au condensateur à diélectrique à air (102 ; 402).

3. Détecteur de fumée selon l'une des revendications précédentes, dans lequel le circuit de mesure de capacité (404) comprend en outre une limite de temps pour le condensateur à diélectrique à air pour changer de la première valeur de capacité à la deuxième valeur de capacité, sinon le circuit d'alarme n'est pas actionné.

4. Détecteur de fumée selon l'une des revendications précédentes, dans lequel le circuit de mesure de capacité (404) est un circuit d'unité de mesure de temps de charge (CTMU).

5. Détecteur de fumée selon l'une des revendications précédentes 1 à 3, dans lequel le circuit de mesure de capacité est un circuit de diviseur de tension capacitif (CVD) ou un circuit de module de détection capacitif (CSM).

6. Détecteur de fumée selon l'une des revendications précédentes 1 à 3, dans lequel le circuit de mesure de capacité comprend :
un circuit de génération de fréquence utilisant le condensateur à diélectrique à air (102 ; 402) en tant que partie d'un circuit de détermination de fréquence de celui-ci ; et
un circuit de discriminateur de fréquence couplé au circuit de génération de fréquence, le circuit de discriminateur de fréquence a une première sortie lorsque le condensateur à diélectrique à air (102 ; 402) est à la première valeur de capacité et a une deuxième output lorsque le condensateur à diélectrique à air est à la deuxième valeur de capacité.

7. Détecteur de fumée selon l'une des revendications précédentes, dans lequel le circuit d'alarme comprend en outre un circuit de mise à l'arrêt (408).

8. Détecteur de fumée selon l'une des revendications précédentes, comprenant en outre un processeur numérique (406) couplé au circuit de mesure de capacité (404) et au circuit d'alarme (408) dans lequel le circuit de mesure de capacité (404), le circuit d'alarme (408) et le processeur numérique (406) sont de préférence fabriqués sur une puce à circuit intégré.

9. Détecteur de fumée selon l'une des revendications précédentes, dans lequel le condensateur à diélectrique à air est monté dans un plénum d'air de retour.

10. Détecteur de fumée selon l'une des revendications précédentes 8 ou 9, comprenant en outre un capteur de température (432) couplé au processeur numérique (406) et une table de consultation de compensation de température stockée dans une mémoire couplée au processeur numérique (406) et utilisée pour compenser les changements induits de température des première et deuxième valeurs de capacité.

11. Détecteur de fumée selon l'une des revendications précédentes 8 à 10, comprenant en outre un capteur d'humidité (434) couplé au processeur numérique (406) et une table de consultation de compensation d'humidité stockée dans une mémoire couplée au processeur numérique (406) et utilisée pour compenser les changements induits d'humidité des première et deuxième valeurs de capacité.

12. Détecteur de fumée selon l'une des revendications précédentes, comprenant en outre une alarme sonore (436) et/ou une alarme visuelle (436) actionnée par le circuit d'alarme (408).

13. Détecteur de fumée selon l'une des revendications précédentes, dans lequel le condensateur à diélectrique à air (102a) comprend deux enveloppes externes en forme de demi-cercle (110, 112) agencées à une distance pour former un cercle, dans lequel, depuis une surface interne de chaque enveloppe (110, 112), des doigts s'étendent de manière alternée de sorte que la structure interdigitale est formée.

14. Procédé de détection de fumée dans l'air utilisant un détecteur de fumée selon l'une des revendications précédentes, ledit procédé comprenant les étapes de :
écoulement d'air sur les plaques du condensateur à diélectrique à air (102 ; 402) ;
détection du fait qu'une augmentation d'une valeur de capacité du condensateur à diélectrique à air (102 ; 402) se produit, de façon à indiquer la présence de fumée dans l'air circulant ; et
génération d'une alarme de fumée lorsque l'augmentation de la valeur de capacité du condensateur à diélectrique à air (102 ; 402) est détectée.

15. Procédé selon la revendication 14, dans lequel, pour déterminer une ligne de base, le procédé comprend en outre les étapes de :
écoulement d'air propre sur les plaques du condensateur à diélectrique à air (102 ; 402) ;
détermination d'une valeur de capacité du condensateur à diélectrique à air (102 ; 402) lorsque l'air propre s'écoule sur la pluralité des plaques du condensateur à diélectrique à air (102 ; 402).
